# EUROPEAN PATENT APPLICATION

(11) **EP 2 280 423 A2**
(43) Date of publication of application: **02.02.2011**
(21) Application number: 09016158.9
(22) Date of filing: 31.12.2009
(51) Int. Cl.: H01L 31/075, H01L 31/18

(54) **Solar cell and method for fabricating the same**

(30) Priority: 30.07.2009 KR 20090070306
(71) Applicant: Samsung Electronics Co., Ltd., Yeongtong-gu Suwon-city, Gyeonggi-do 442-742 (KR)
(72) Inventor: Jung, Seung-Jae, Gwanak-gu, Seoul (KR)
(74) Representative: Weitzel, Wolfgang

(57) **Abstract**

A solar cell includes a first electrode (110) disposed on a substrate (100), a first light absorption layer disposed on the first electrode, an interlayer (150) disposed on the first light absorption layer, a second light absorption layer disposed on the interlayer, and a second electrode (200) disposed on the second light absorption layer. The solar cell further includes a groove (G2) penetrating through the first light absorption layer, the interlayer, and the second light absorption layer. The groove (G2) is filled with the second electrode (200). The interlayer (150) is spaced apart from the second electrode filling the groove, to define a spacer layer (S) which electrically insulates the interlayer (150) from the second electrode (200) filling the groove.

## Description

### BACKGROUND OF THE INVENTION

### 1. Field of the Invention

This disclosure relates to a solar cell and a method of fabricating the same.

### 2. Description of the Related Art

A solar cell converts solar energy into electrical energy. Basically, solar cells are diodes of junctions formed by joining p-type and n-type semiconductors together in very close contact (e.g., "PN" junction"), and they are divided into diverse kinds according to a material used as a light absorption layer.

Solar cells using silicon as a light absorption layer are divided into a crystalline (e.g., monocrystalline or polycrystalline) wafer solar cell, and a thin film (e.g., crystalline or amorphous) solar cell.

A thin film solar cell is fabricated by forming a film on a thin glass or plastic substrate. A thin film generally has a short diffusion range of a carrier, compared to a crystalline wafer solar cell. When a solar cell is formed of only a PN junction structure, the collection efficiency of electron-hole pairs generated by solar light is so low that the solar cell may employ a PIN structure in which a light absorption layer of an intrinsic ("I") semiconductor material having a high light absorption rate is interposed between a p-type semiconductor and an n-type semiconductor.

The structure of a general thin film solar cell includes a front transparent conductive layer, a single PIN layer, and a rear reflecting electrode layer sequentially deposited over a substrate. In this structure, the light absorption layer is depleted by a P layer and an N layer having a high doping concentration in the upper and lower parts, to thereby form an electric field inside the solar cell. Thus, electrons and holes of the carriers produced by solar light in the light absorption layer are collected in the N layer and the P layer, respectively, by drift of the internal electric field of the solar cell, to thereby generate an electric current.

Since a thin film solar cell using amorphous silicon ("a-Si:H") and microcrystalline silicon ("mc-Si:H") uses a thin film having a thickness equal to or less than several microns as a light absorption layer, and since silicon has a low light absorption coefficient in itself, there is a limitation in achieving high efficiency with a single PIN junction. Therefore, a tandem solar cell is fabricated by stacking an amorphous silicon ("a-Si:H") solar cell of a PIN structure and a crystal silicon ("mc-Si:H") solar cell of a PIN structure, in two or three layers. Open voltage may be increased by connecting the solar cells in series, and the conversion efficiency of incident light may be improved.

### BRIEF SUMMARY OF THE INVENTION

Exemplary embodiments of the described technology has been made in an effort to provide a solar cell capable of improving the efficiency of a tandem solar cell, and a method for fabricating the same.

According to an exemplary embodiment of the invention, a solar cell is provided including a first electrode disposed on a substrate, a first light absorption layer disposed on the first electrode, an interlayer disposed on the first light absorption layer, a second light absorption layer disposed on the interlayer, and a second electrode disposed on the second light absorption layer. The solar cell further includes a groove penetrating the first light absorption layer, the interlayer, and the second light absorption layer. The groove is filled with the second electrode. The interlayer is spaced apart from the second electrode filling the groove to define a spacer layer which electrically insulates the interlayer from the second electrode filling the groove.

The spacer layer may be an empty space where a portion of the interlayer has been removed.

The interlayer may include one of zinc oxide ("ZnO"), indium tin oxide ("ITO"), and tin oxide ("SnO").

The interlayer may have a thickness of about 50 angstroms (Å) to about 3000 angstroms (Å).

A width of the spacer layer corresponding to the empty space between the interlayer and the second electrode filling the groove may range from about 1 micrometer (um) to about 5 micrometers (um).

The spacer layer may have a thickness-to-width ratio of greater than 1 to about 5.

The interlayer may include a material having a refractive index of about 1.5 to about 2.5.

At least one of the first light absorption layer and the second light absorption layer may include a P layer, an I layer, and an N layer sequentially stacked therein.

According to another exemplary embodiment of the invention, a method for fabricating a solar cell includes forming a first electrode on a substrate, patterning the first electrode, forming a first light absorption layer on the first electrode, forming an interlayer on the first light absorption layer, forming the second light absorption layer on the interlayer, forming a groove by patterning the first light absorption layer, the interlayer, and the second light absorption layer, etching the interlayer exposed through the groove, and forming a second electrode on the second light absorption layer to fill the groove.

The interlayer may be etched in such a manner that an edge of the interlayer retreats away from the groove in an area of the interlayer between the first light absorption layer and the second light absorption layer.

The second electrode filling the groove may be electrically insulated from the interlayer.

The etching the interlayer may include cleaning an upper surface of the second light absorption layer.

The interlayer may include one of zinc oxide ("ZnO"), indium tin oxide ("ITO"), and tin oxide ("SnO").

The interlayer may have a thickness of about 50 Å to about 3000 Å.

The etching the interlayer forms a spacer layer corresponding to an empty space between the interlayer and the second electrode filling the groove, the spacer layer having a width of about 1um to about 5um.

### BRIEF DESCRIPTION OF THE DRAWINGS

FIG. 1 is a cross-sectional view of an exemplary embodiment of a solar cell, according to the invention.
FIGS. 2 to 6 are cross-sectional views showing an exemplary embodiment of a method of forming a solar cell, according to the invention.

### DETAILED DESCRIPTION OF THE INVENTION

Exemplary embodiments will hereinafter be described in detail referring to the following accompanied drawings such that they can be easily performed by those who have common knowledge in the related field. However, these embodiments are only exemplary, and this disclosure is not limited thereto. The exemplary embodiments disclosed hereinafter are provided to make a person of ordinary skill in the art sufficiently understand the present disclosures.

In the drawings, the thickness of layers, regions, etc., are exaggerated for clarity. It will be understood that when an element such as a layer, region, or substrate is referred to as being "on' another element, it can be directly on the other element or intervening elements may also be present. Like reference numerals designate like elements throughout the specification. As used herein, connected may refer to elements being physically and/or electrically connected to each other. As used herein, the term "and/ or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper" relative to the other elements or features. Thus, the exemplary term "lower" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the invention will be described in detail with reference to the accompanying drawings.

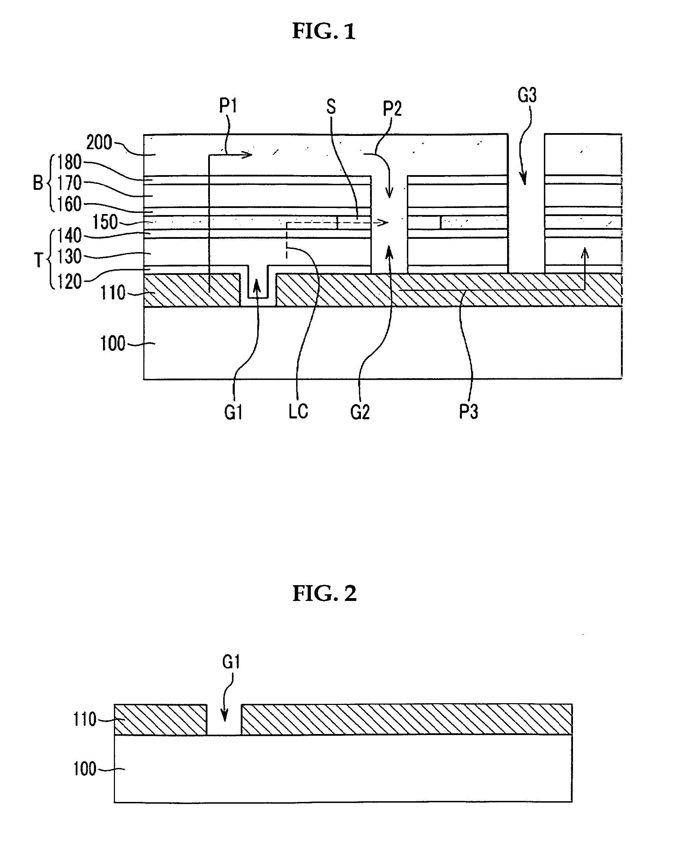

FIG. 1 is a cross-sectional view of an exemplary embodiment of a solar cell, according to the invention. The illustrated solar cell may also be referred to as a tandem solar cell. FIG. 1 shows a portion of two adjacent cells (e.g., unit cells) of the tandem solar cell.

Referring to FIG. 1, the solar cell according to the exemplary embodiment includes a first electrode 110 disposed on a substrate 100. The substrate 100 may be a glass substrate. The first electrode 110 may function as a lower electrode of the solar cell. The first electrode 110 may include tin dioxide (SnO₂) aluminum doped zinc oxide ("ZnO:Al"), boron doped zinc oxide ("ZnO:B"), gallium doped zinc oxide ("ZnO:Ga"), indium tin oxide ("ITO"), or indium zinc oxide ("IZO").

An upper and/or an lower surface of the first electrode 110 may be texturized. Texturizing the surface of the first electrode 110 reduces light reflection on the surface into which solar light enters, to thereby increase the amount of effective light absorbed into the solar cell. The textured surface of the first electrode 110 may be formed unevenly like the surface of fabric.

A first P layer 120 including a p-type impurity, a first I layer 130 including an intrinsic semiconductor, and a first N layer 140 including an n-type impurity, are sequentially stacked on the first electrode 110, in a direction away from the substrate 100. The first I layer 130 serves as a light absorption layer, and the first I layer 130 may be a path through which carriers are transferred from the first P layer 120 to the first N layer 140 by generating an electric field. In an exemplary embodiment of the solar cell, among the carriers produced by solar light in the first I layer 130, which is a light absorption layer, electrons are collected in the first N layer 140 while holes are collected in the first P layer 120 by the drift of the internal electric field, to thereby generate an electric current.

A first groove G1 is disposed to penetrate completely through the first electrode 110. The first groove G1 is completely filled with portions of both the first P layer 120, and the first I layer 130 which is disposed on the first P layer 120.

In an exemplary embodiment, the first P layer 120 may be at least one of boron-doped amorphous silicon ("boron doped a-Si:H"), amorphous silicon carbide ("a-SiC:H"), and microcrystalline silicon ("mc-Si:H"). The first I layer 130 and/or the first N layer 140, which are light absorption layers, may include amorphous silicon ("a-Si:H").

The first P layer 120, the first I layer 130, and the first N layer 140 may collectively form a top cell layer ("T") in the tandem solar cell, according to an exemplary embodiment of the invention. The first N layer 140 is the uppermost layer of the top cell layer T, where the first P layer 120 is the lowermost layer of the top cell T, as illustrated in FIG.1.

An interlayer 150 may be disposed directly on the first N layer 140. A bottom cell layer ("B") may be collectively formed by sequentially depositing a second P layer 160, a second I layer 170, and a second N layer 180 directly on the interlayer 150. What has been described above regarding the first P layer 120, the first I layer 130, and the first N layer 140, may be equally applied to a second P layer 160, a second I layer 170, and a second N layer 180, and repetitive description is omitted. The second N layer 180 is the uppermost layer of the bottom cell layer B, where the second P layer 160 is the lowermost layer of the bottom cell B, as illustrated in FIG.1.

The top cell layer T is disposed in such a manner that solar light entering through the substrate 100 reaches the top cell layer T earlier than the bottom cell layer B. Referring to FIG. 1, solar light is incident on a lower surface of the substrate 100 and passes through the substrate 100 and the first electrode 110 to reach the top cell layer T.

The interlayer 150 performs a function of increasing light efficiency in the tandem solar cell structure, according to an exemplary embodiment of the invention. Referring again to FIG. 1, the interlayer 150 may electrically connect the top cell layer T and the bottom cell layer B. The interlayer 150 may reflect part of the solar light that is not absorbed in the top cell layer T, which is then transmitted through the top cell layer T and enters the bottom cell layer B to be then transmitted back to the top cell layer T.

For the interlayer 150 to reflect part of the solar light that is not absorbed in the top cell layer T, the interlayer 150 may include a material that is conductive, but has a smaller refractive index than a refractive index of silicon. In the illustrated embodiment, when the top cell layer T includes amorphous silicon, the refractive index of top cell layer T is about 3.5. When the interlayer 150 includes a material having a smaller refractive index than the amorphous silicon, the difference in refractive indexes may cause reflection. In exemplary embodiments, the interlayer 150 may include a material having a refractive index of about 1.5 to about 2.5, and in one exemplary embodiment, the interlayer 150 includes a material having a refractive index of about 1.9 to about 2.0.

The interlayer 150 may include a conductive inorganic oxide or a conductive transparent metal oxide. Non-limiting examples of the conductive transparent include metal oxide include ZnO, indium gallium zinc oxide ("IGZO"), ITO and SiO₂ The interlayer 150 may include SiC and SiNx doped with an n-type material. The interlayer 150 may have a thickness ranging from about 50 angstroms (Å) to about 3000 Å. In one exemplary embodiment, the interlayer 150 may have a thickness ranging from about 100 Å to about 1000 Å, where the thickness is taken in a first direction perpendicular to the substrate 100.

Referring again to FIG. 1, a second electrode 200 is disposed directly on the bottom cell layer B. A second groove G2 is disposed to penetrate completely through each of the top cell layer T, the interlayer 150, and the bottom cell layer B. The second groove G2 is completely filled with a portion of the second electrode 200. The second groove G2 is a single unitary and indivisible member, and forms a continuous area where portions of the top cell layer T, the interlayer 150, and the bottom cell layer B have been respectively removed. In a plan view of the solar cell, the top cell layer T, the interlayer 150 and the bottom cell layer B surround and solely define the second groove G2.

In the illustrated embodiment, a spacer layer ("S") is disposed between the interlayer 150 and the portion of the second electrode 200 which fills the second groove G2. The spacer layer S is considered disposed between the interlayer 150 and the portion of the second electrode 200, in a second direction which is parallel to the upper surface of the substrate 100, and perpendicular to the first direction. The spacer layer S is an empty space (e.g., gap) that is not filled with any material of the solar cell. The spacer layer is open (e.g., exposed) to the portion of the second electrode 200 filling the second groove G2.

The spacer layer S corresponding to the gap between an inner edge of the interlayer 150 and an outer edge of the portion of the second electrode 200 filling the second groove G2, may have a width taken in the second direction ranging from about 1 micrometer (um) to about 5 micrometers (um). The spacer layer S extends towards the interlayer 150 from the outer edge of the portion of the second electrode 200 at a distance of the width of the spacer layer S. The spacer layer S may have a thickness-to-width ratio of about 1 to about 5. In one exemplary embodiment, the thickness-to-width ratio is greater than 1 to about 5. The thickness of the spacer layer S is taken in the first direction, and is substantially the same as the thickness of the interlayer 150. Herein, the width of the spacer layer S signifies a length that is electrically insulated as the interlayer 150 retreats during a forming process.

The spacer layer S electrically insulates the interlayer 150 from the portion of the second electrode 200 filling the second groove G2. Without the spacer layer S, electric current generated in the top cell layer T does not flow toward the bottom cell layer B, and leakage current ("LC") leaking out toward the second electrode 200 through the interlayer 150 may be generated, as illustrated by the dotted line in FIG. 1.

A third groove G3 is disposed to penetrate completely through all of the top cell layer T, the interlayer 150, the bottom cell layer B, and the second electrode 200. The third groove G3 is a single unitary and indivisible member, and forms a continuous area where portions of the top cell layer T, the interlayer 150, the bottom cell layer B and the second electrode 200 have been respectively removed. In a plan view of the solar cell, the top cell layer T, the interlayer 150, the bottom cell layer B and the second electrode 200 surround and solely define the third groove G3.

The first groove G1 insulates the first electrode 110 from an adjacent first electrode 110. The second groove G2 electrically connects the first electrode 110 and the second electrode 200 that correspond to a lower electrode and an upper electrode, respectively. Also, the third groove G3 insulates adjacent unit cells from each other, in a solar cell including a plurality of unit cells (not shown).

In the solar cell according to the illustrated exemplary embodiment shown in FIG. 1, electric current generated in the first and second I layers 130 and 170, which are light absorption layers, passes through a first path P1, a second path P2, and a third path P3 to thereby connect adjacent cells of the solar cell in series. Since the electric current generated in the first and second I layers 130 and 170 of the first (left) unit cell in FIG. 1 effectively travels from the first electrode 110 of the first unit cell, and to the first electrode 110 of a second (right) unit cell in FIG. 1, the adjacent first and second unit cells are electrically connected in series.

In contrast to a conventional solar cell including only a single PIN junction, the invention includes a tandem solar cell, which more than one of the PIN junction structure, disposed in more than one layer. Furthermore, since the tandem solar cells including the more than one PIN structure are connected in series, the conversion efficiency of incident light may be improved.

Hereinafter, an exemplary embodiment of a method for fabricating a solar cell in accordance with the invention will be described.

FIGS. 2 to 6 are cross-sectional views showing an exemplary embodiment of a method of manufacturing a solar cell, according to the invention.

Referring to FIG. 2, a first electrode 110 is deposited on the substrate 100 and patterned to thereby form the first groove G1.

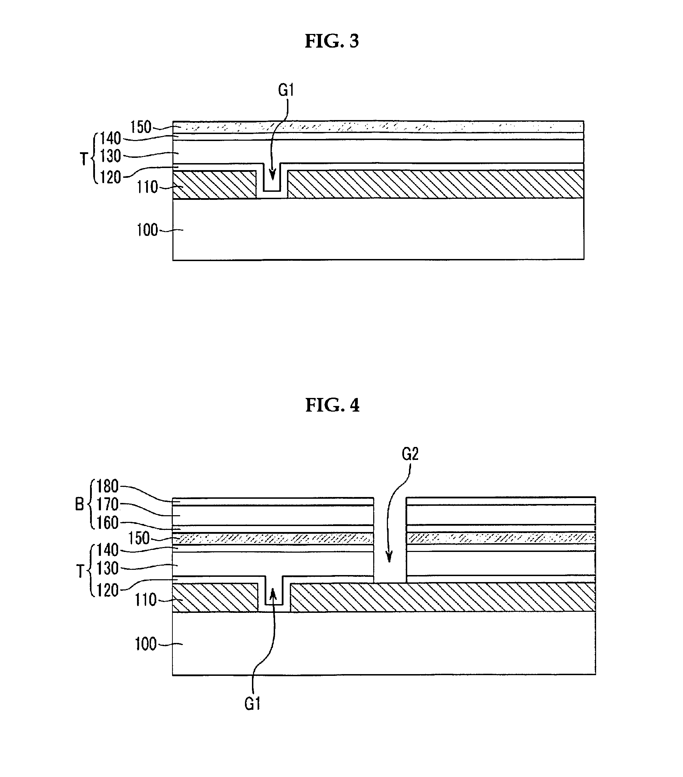

Referring to FIG. 3, a top cell layer T including the first P layer 120, the first I layer 130, and the first N layer 140 stacked sequentially over the electrode 110, is formed. Subsequently, the interlayer 150 is formed on an uppermost surface of the top cell T. The first P layer 120 may directly cover (e.g., overlap) the sidewalls and a lower surface of the first groove G1, that is, partially fill the first groove G1. The first I layer 130 formed directly over the first P layer 120 may partially fill the first groove G1. The first P layer 120 and the first I layer 130 together completely fill the first groove G1.

The interlayer 150 may be formed in a thickness taken in the first direction perpendicular to the substrate 100, ranging from about 50 Å to about 3000 Å. In one exemplary embodiment, the interlayer may be formed in a thickness ranging from about 100 Å to about 1000 Å.

The interlayer 150 may be formed of a material that is conductive and that has a smaller refractive index than silicon. In other words, since the top cell layer T may have a refractive index of about 3.5 when the top cell layer T includes amorphous silicon, reflection may occur due to the difference in refractive indexes when the interlayer 150 is formed of a material having a smaller refractive index than the top cell layer T.

In an exemplary embodiment, the first P layer 120, the first I layer 130 and the first N layer 140 may be deposited through plasma enhanced chemical vapor deposition ("PECVD").

Referring to FIG. 4, a bottom cell layer B including a second P layer 160, a second I layer 170, and a second N layer 180 stacked sequentially over the interlayer 150, is formed on an uppermost surface of the interlayer 150. Subsequently, a second groove G2 is formed by patterning the top cell layer T, the interlayer 150, and the bottom cell layer B, such that the second groove G2 completely penetrates the top cell layer T, the interlayer 150, and the bottom cell layer B. The second groove G2 is a single unitary and indivisible member, and forms a continuous area where portions of the top cell layer T, the interlayer 150, and the bottom cell layer B have been respectively removed.

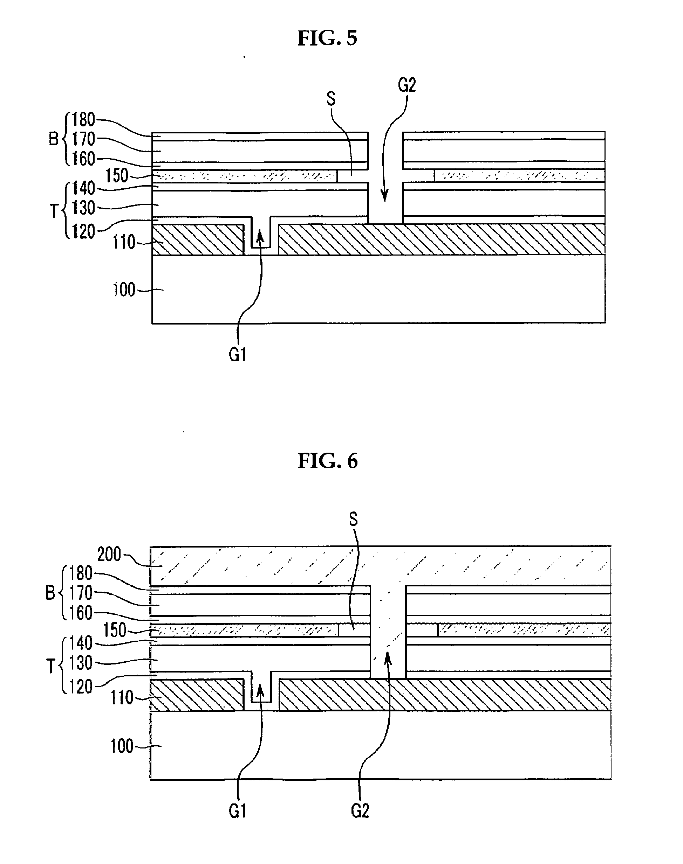

Referring to FIG. 5, a wet etching process is performed on the structure including the formed top cell layer T, the interlayer 150, and the bottom cell layer B. The wet etching process may make the interlayer 150 retreat inwardly between the top cell layer T and the bottom cell layer B. To be specific, inner sidewalls of the interlayer 150 exposed through the second groove G2, may be etched in a direction away from the second groove G2 through the wet etching process.

In an exemplary embodiment, the wet etching process may be performed using an acidic solution, such as hydrochloric acid, hydrofluoric acid, nitric acid, acetic acid, and the like, and the interlayer 150 may be formed of zinc oxide ("ZnO") that may be easily etched. However, the interlayer 150 is not be limited thereto, and the interlayer 150 may be formed of ITO or tin oxide ("SnO").

The etch extent of the interlayer 150 may be controlled in such a manner that a horizontal (e.g., second direction) distance between a sidewall of the after-etching interlayer 150 and the second groove G2 ranges from about 1um to about 5um.

Instead of separately performing the wet etching process, in an alternative exemplary embodiment, the upper surface of the bottom cell layer B corresponding to a thin film, may be cleaned with hydrogen fluoride (HF). The HF cleaning may etch the interlayer 150 while removing particles and a natural oxide layer generated from the previous process at a same time.

The first electrode 110 may be etched while etching the interlayer 150 because a portion of the upper surface of the first electrode 110 is exposed through the second groove G2. When the interlayer 150 and the first electrode 110 are formed of the same material, it is difficult to acquire etch selectivity. Therefore, the interlayer 150 may be formed of a material whose etch rate is faster than an etch rate of the first electrode 110. In one exemplary embodiment, the etch selectivity may be sufficiently acquired when the first electrode 110 is formed of ITO or SnO, and the interlayer 150 is formed of ZnO.

In the case of ZnO, the layer crystallinity or microstructure may be different according to deposition temperature. In an alternative exemplary embodiment, when the deposition process of the ZnO is different, the etch selectivity between the interlayer 150 and the first electrode 110 may be acquired. Generally, ZnO deposited at a high temperature has a much slower etch rate than ZnO deposited at room temperature. Therefore, when the interlayer 150 and the first electrode 110 are both formed of ZnO, the first electrode 110 may be deposited at the high temperature.

In one exemplary embodiment, when the first electrode 110 is deposited through a sputtering method, the first electrode may be deposited at a temperature ranging from about 100 Celcius (°C) to about 250 Celcius (°C). In another exemplary embodiment, when the first electrode 110 is deposited through a chemical vapor deposition ("CVD") method, it may be deposited at a temperature ranging from about 150°C to about 250°C.

Referring to FIG. 6, the interlayer 150 is etched, and a second electrode 200 is formed to fill the second groove G2 and be disposed overlapping an entire of the bottom cell layer B.

A spacer layer S is formed between the sidewall of the interlayer 150 and the second electrode 200 filling the second groove G2. The spacer layer S is substantially an empty space formed by etching a portion of the interlayer 150, to remove the portion of the interlayer 150. The spacer layer S electrically insulates the interlayer 150 from the second electrode 200, by disposing a distance without any material between the interlayer 150 and the second electrode 200.

The spacer layer S may be formed to have a width in the second direction parallel to the upper surface of the substrate 100, of about 1um to about 5um. The spacer layer S may have a thickness-to-width ratio of about 1 to about 5. In one exemplary embodiment, the thickness-to-width ratio is greater than 1 to about 5. The width of the spacer layer S denotes the length that is electrically insulated as the interlayer 150 retreats from the second electrode 200 disposed in the second groove G2.

When a third groove G3 is formed by patterning the second electrode 200, the bottom cell layer B, the interlayer 150, and the top cell layer T, a solar cell of a structure illustrated in FIG. 1 is formed.

The third groove G3 partitions adjacent unit cells.

The first groove G1, the second groove G2, and/or the third groove G3 may be formed using a laser patterning method. In the laser patterning, the laser may be irradiated from a lower portion of the substrate 100, to the top cell layer T or the bottom cell layer B, respectively.

While this disclosure has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A solar cell comprising:
a first electrode disposed on a substrate;
a first light absorption layer disposed on the first electrode;
an interlayer disposed on the first light absorption layer;
a second light absorption layer disposed on the interlayer;
a second electrode disposed on the second light absorption layer; and
a groove penetrating through the first light absorption layer, the interlayer, and the second light absorption layer;
wherein
a portion of the second electrode is disposed in an entire of the groove, and
the interlayer is spaced apart from the portion of the second electrode disposed in the groove to define a spacer layer, which electrically insulates the interlayer from the portion of the second electrode filling the groove.

2. The solar cell of claim 1, wherein the spacer layer is an empty space.

3. The solar cell of claim 2, wherein the interlayer comprises at least one of zinc oxide, indium tin oxide, and tin oxide.

4. The solar cell of claim 3, wherein the interlayer has a thickness of about 50 angstroms (Å) to about 3000 angstroms (Å), the thickness of the interlayer taken perpendicular to the substrate.

5. The solar cell of claim 4, wherein a width of the spacer layer corresponding to the empty space between the interlayer and the second electrode filling the groove, ranges from about 1 micrometer to about 5 micrometers, the width of the spacer layer taken parallel to the substrate.

6. The solar cell of claim 5, wherein the spacer layer has a thickness-to-width ratio of greater than 1 to about 5, the thickness of the spacer layer taken perpendicular to the width of the spacer layer.

7. The solar cell of claim 1, wherein the interlayer comprises a material having a refractive index of about 1.5 to about 2.5.

8. The solar cell of claim 1, wherein at least one of the first light absorption layer and the second light absorption layer includes a P layer including a p-type impurity, an I layer including an intrinsic semiconductor, and an N layer including a n-type impurity, sequentially stacked.

9. A method for fabricating a solar cell, the method comprising:
forming a first electrode on a substrate;
patterning the first electrode;
forming a first light absorption layer on the first electrode;
forming an interlayer on the first light absorption layer;
forming the second light absorption layer on the interlayer;
forming a groove penetrating the first light absorption layer, the interlayer, and the second light absorption layer, by patterning the first light absorption layer, the interlayer, and the second light absorption layer;
etching the interlayer exposed through the groove; and
forming a second electrode on the second light absorption layer to fill the groove and be electrically connected to the first electrode.

10. The method of claim 9, wherein the interlayer is etched such that an edge of the interlayer retreats away from the groove, in an area of the interlayer between the first light absorption layer and the second light absorption layer.

11. The method of claim 9, wherein the second electrode filling the groove is electrically insulated from the interlayer.

12. The method of claim 9, wherein the etching the interlayer includes cleaning an upper surface of the second light absorption layer.

13. The method of claim 9, wherein the interlayer comprises one of zinc oxide, indium tin oxide, and tin oxide.

14. The method of claim 13, wherein the interlayer has a thickness of about 50 angstroms (Å) to about 3000 angstroms (A), the thickness of the interlayer taken perpendicular to the substrate.

15. The method of claim 14, wherein the etching the interlayer forms a spacer layer corresponding to an empty space between the interlayer and the second electrode filling the groove, the spacer layer having a width of about 1 micrometer to about 5 micrometers taken parallel to the substrate.
